Europäisches Patentamt

European Patent Office

Office européen des brevets

(19)

(11) Veröffentlichungsnummer: **0 318 768 B1**

(12) **EUROPÄISCHE PATENTSCHRIFT**

(45) Veröffentlichungstag der Patentschrift: **17.06.92**

(51) Int. Cl.⁵: **G06F 11/22**

(21) Anmeldenummer: **88119171.2**

(22) Anmeldetag: **18.11.88**

(54) **Logikanalysator.**

(30) Priorität: **30.11.87 CH 4655/87**

(43) Veröffentlichungstag der Anmeldung:
**07.06.89 Patentblatt 89/23**

(45) Bekanntmachung des Hinweises auf die
Patenterteilung:
**17.06.92 Patentblatt 92/25**

(84) Benannte Vertragsstaaten:
**CH DE ES FR GB IT LI**

(56) Entgegenhaltungen:
**EP-A- 0 181 619**
**DE-C- 3 611 872**
**US-A- 4 697 138**

**HEWLETT-PACKARD JOURNAL, Band 34, Nr.
7, Juli 1983, Seiten 14-25, Amstelveen, NL; D.
KIBLE et al.: "High-speed data analyzer tests
threshold and timing parameters"**

**PATENT ABSTRACTS OF JAPAN, Band 11,
Nr. 147 (P-575), 14. Mai 1987; & JP-A-61 284
668 (ANDO ELECTRIC CO., LTD) 15-12-1986**

(73) Patentinhaber: **KONTRON ELEKTRONIK GMBH
Oskar-von-Miller-Strasse 1
W-8057 Eching(DE)**

(72) Erfinder: **Horak, Dieter Klaus
Am Mühlbachbogen 51 f
W-8052 Moosburg a.d. Isar(DE)**
Erfinder: **Wieczorek, Rudolf
Redlinger Platz 16
W-8000 München 83(DE)**

(74) Vertreter: **Dirscherl, Josef
c/o Bayerische Motoren Werke Aktiengesellschaft, Patentabteilung AJ-3, Postfach 40 02
40, Petuelring 130
W-8000 München 40(DE)**

EP 0 318 768 B1

## Beschreibung

Die Erfindung betrifft einen Logikanalysator nach dem Oberbegriff des Patentanspruchs 1.

Digitale elektronische Geräte enthalten Mikroprozessoren, die zusammenarbeiten und komplexe Funktionen ermöglichen. Zur Entwicklung, Eichung und Prüfung solcher Geräte sind geeignete Meßinstrumente in Form von Logikanalysatoren erforderlich.

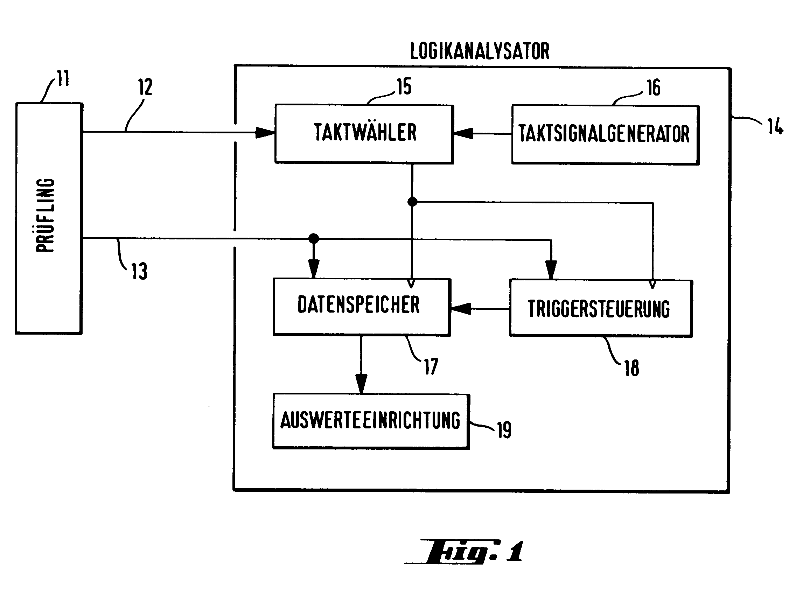

Die beiliegende Fig. 1 zeigt den Aufbau eines konventionellen Logikanalysators 14. Dieser enthält einen Taktwähler 15, mit dem entweder ein externes, von einem Prüfling 11 abgeleitetes und dem Logikanalysator 14 über eine Leitung 12 zugeführtes Taktsignal oder ein internes, vom Taktsignalgenerator 16 des Logikanalysators 14 abgegebenes Taktsignal gewählt und an seinem Ausgang abgegeben wird. Der Logikanalysator 14 enthält ferner einen Datenspeicher 17, in dem Datensignale gespeichert werden, die vom Prüfling 11 über Datenleitungen 13 abgegeben und mit Hilfe des Taktsignals am Ausgangstaktwähler 15 abgetastet werden, und eine Triggersteuerung 18. Die Speicherung der Datensignale im Datenspeicher 17 wird von der Triggersteuerung 18 gestoppt, wenn eine vorgegebene Triggerbedingung erfüllt wird. Der Logikanalysator enthält außerdem eine Auswerteeinrichtung 19. Diese Einrichtung enthält einen Datenprozessor und eine Eingabe/Ausgabeeinheit und dient zur Auswertung der gespeicherten Datensignale, zur Eingabe von Instruktionen und zur Sichtbarmachung der gewünschten Darstellung der gespeicherten Datensignale.

Mit den meisten bisher bekannten Legikanalysatoren können nur Datensignale einzelner Prüfobjekte, z. B. einzelner Mikroprozessoren, gemessen werden, wobei Zeitbezüge zwischen den Datensignalen verschiedener Prüfobjekte in die Triggerungssteuerung nicht einbezogen werden können.

Es ist ein Legikanalysator bekannt (EP-A 0 181 619), der eine erste Analysator-Sektion und eine zweite Analysator-Sektion enthält. Mit der ersten Analysator-Sektion kann z. B. eine Zustandsanalyse von einem ersten Block von Datensignalen durchgeführt werden. Mit der zweiten Analysator-Sektion wird z. B. eine Zeitanalyse von einem zweiten Block von Datensignalen durchgeführt. Die erste Analysator-Sektion enthält eine Zeitintervall-Meßschaltung, mit der die zeitlichen Abstände aller Abtastungen in der ersten Analysator-Sektion erfaßt werden, und einen Zeitintervall-Speicher in dem die gemessenen Abstände gespeichert werden. Der Logikanalysator enthält außerdem eine Zeitdifferenz-Meßschaltung und einen Zeitdifferenz-Speicher, mit denen der zeitliche Abstand zwischen den Aufzeichnungs-Enden in der ersten Analysator-Sektion und in der zweiten Analysator-Sektion gemessen bzw. gespeichert werden. Anhand der in dem Zeitintervall-Speicher und in dem Zeitdifferenz-Speicher gespeicherten Werte läßt sich durch eine nach der Triggerung durchgeführte Verarbeitung der aufgezeichneten Datensignale eine zeitlich korrelierte Darstellung der mit der ersten Analysator-Sektion und mit der zweiten Analysator-Sektion aufgezeichneten Datensignale erzeugen. Dies ist jedoch nur für zwei Analysator-Sektionen, d. h. nur für zwei verschiedene Blöcke von Datensignalen möglich. Es ist außerdem auch mit diesem bekannten Logikanalysator nicht möglich, Zeitbezüge zwischen den gemessenen Datensignalen in die Triggersteuerung einzubeziehen.

In der DE-C 36 11 872 ist ein Legikanalysator beschrieben, mit dem mehrere voneinander unabhängig verlaufende Prozesse analysiert werden können, die zeitlich völlig unkorreliert ablaufen. Dazu werden alle Daten der Datenkanäle taktkanalspezifisch in zugeordneten Zwischenspeichern zwischengespeichert und bleiben dort solange, bis sie mit dem Systemtakt eines Systemtaktgenerators in einen Datenspeicher übernommen werden. Nach dem Einspeichern der Daten im Zwischenspeicher setzt der entsprechende Zwischenspeicher ein Anforderungssignal für eine Synchronisierschaltung, die beim nächstmöglichen Systemtaktzyklus die Daten vom Zwischenspeicher übernimmt und diese für erneute Abspeicherung freigibt. Die Synchronisierschaltung ist mit einer Ablaufsteuerung verbunden, über welche die Daten in den Datenspeicher eingespeichert werden. Wenn aufeinanderfolgende Taktsignale von verschiedenen Taktkanälen in einem größeren Abstand als der Systemtakt auftreten, werden die in den Zwischenspeichern abgespeicherten Daten sofort über die Synchronisierschaltung und die Ablaufsteuerschaltung dem Datenspeicher zugeführt und dort abgespeichert, während wenn dagegen zwei oder mehrere Taktsignale in einem kleineren Abstand als der Systemtakt auftreten, werden die in den Zwischenspeichern abgespeicherten Daten gemäß einer von der Synchronisierschaltung vorgegebenen Reihenfolge freigegeben. Die Synchronisierschaltung stellt die jeweilige Verweildauer der Daten in den einzelnen Zwischenspeichern fest und schaltet die Daten mit der längsten Verweildauer zuerst zur Ablaufsteuerung und damit zum Datenspeicher durch. Auch mit diesem bekannten Logikanalysator ist es nicht möglich, Zeitbezüge zwischen den gemessenen Datensignalen in die Triggersteuerung einzubeziehen.

Bei der Untersuchung komplexer digitaler Systeme, die in der Regel mehrere, zusammenarbeitende Mikroprozessoren enthalten, ist es jedoch erwünscht, die tatsächliche Dauer von zeitlich unkorrelierten Daten- bzw. Worte-Bereichen in Datensignalen, die von einer Vielzahl verschiedener Mikroprozessoren, d. h. verschiedener Prüfobjekte entnommen werden, und/oder den tatsächlichen zeitlichen Abstand zwischen solchen Daten- bzw. Worte-Bereichen als Kriterium für die Triggersteuerung und die Aufzeichnungssteuerung zu verwenden. Dies ist jedoch mit den bisher bekannten Legikanalysatoren nicht möglich.

Es ist daher Aufgabe der Erfindung, einen Legikanalysator zu schaffen, mit dem Zeitbezüge zwischen den gemessenen Datensignalen in die Triggersteuerung mit einbezogen werden können.

Diese Aufgabe wird gemäß der Erfindung durch einen Logikanalysator mit den im Patentanspruch 1 angegebenen Merkmalen gelöst.

Mit dem erfindungsgemäßen Legikanalysator ist es nun möglich geworden, die tatsächliche Dauer von zeitlich unkorrelierten Daten- bzw. Worte-Bereiche aus einer Vielzahl verschiedener Prüfobjekte, z. B. Mikroprozesssoren, und/oder den tatsächlichen zeitlichen Abstand zwischen solchen Daten- bzw. Worte-Bereichen als Kriterium für die Triggersteuerung und die Aufzeichnungssteuerung zu verwenden, und zwar unabhängig davon, ob die von jedem Prüfobjekt abgegebenen und den Eingängen des Legikanalysators zugeführten Datensignale mit einem externen, vom Taktsignal des Prüfobjektes abgeleiteten Taktsignal oder mit einem internen konstanten Taktsignal des Logikanalysators abgetastet werden. Dies gilt auch wenn Datensignale von mehreren Prüfobjekten analysiert werden, deren Taktsignale eine unbekannte Periodendauer haben, und wenn die zeitliche Zuordnung zwischen diesen Taktsignalen auch unbekannt ist.

Im folgenden wird anhand der beiliegenden Zeichnungen ein Ausführungsbeispiel der Erfindung beschrieben. Es zeigen:

Fig. 1  ein Blockdiagramm eines konventionellen Logikanalysators.

Fig. 2  ein Blockdiagramm eines erfindungsgemässen Logikanalysators

Fig. 3-10  Blockdiagramme der in Fig. 2 gezeigten Blöcke

Fig. 11-16  Signaldiagramme für einige Anwendungsbeispiele.

In den beiliegenden Figuren sind die Blöcke bzw. Signale mit den in Englisch üblichen Bezeichnungen beschriftet.

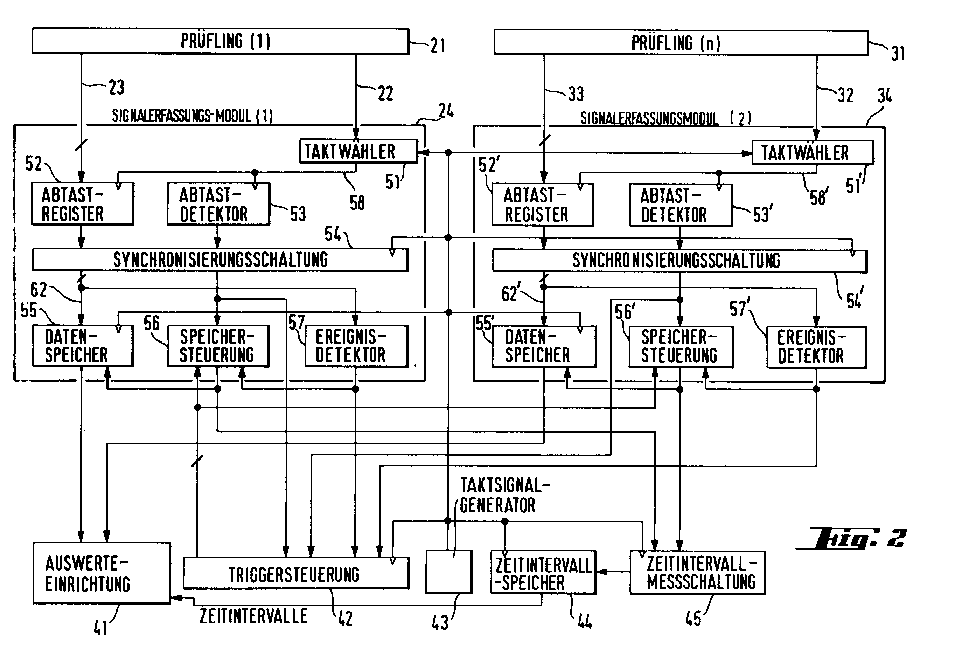

Die Fig. 2 zeigt eine bevorzugte Ausführungsform eines erfindungsgemässen Logikanalysators. Dieser enthält eine Vielzahl von Signalerfassungsmodulen 24,34, mit denen Datensignale von einer entsprechenden Vielzahl von Prüflingen 21,31 gemessen werden können. Die wesentlichen Vorteile des erfindungsgemässen Logikanalysators sind jedoch auch dann erzielbar, wenn nur ein Signalerfassungsmodul zur Messung der Datensignale eines einzigen Prüflings verwendet wird.

Zur Vereinfachung der Darstellung werden in Fig. 2 nur ein erstes Signalerfassungsmodul 24 und ein zweites Signalerfassungsmodul 34 dargestellt. Im Prinzip können aber n solcher Module vorgesehen werden, wobei n gleich oder grösser als eins sein kann.

Wie aus Fig. 2 ersichtlich, wird jedem Prüfling ein Signalerfassungsmodul zugeordnet; dem Prüfling 21 ist das Signalerfassungsmodul 24 und dem Prüfling 31 ist das Signalerfassungsmodul 34 zugeordnet.

Jedes Signalerfassungsmodul empfängt von dem ihm zugeordneten Prüfling Datensignale und ein Taktsignal. Die Datensignale werden über eine Vielzahl Leitungen 23 bzw. 33 übertragen. Die Taktsignale werden über Leitungen 22 bzw. 32 übertragen.

Der Logikanalysator gemäss Fig. 2 enthält ausserdem einen internen Taktsignalgenerator 43, eine Triggersteuerung 42, eine Zeitintervall-Messchaltung 45, einen Zeitintervall-Speicher 44 und eine Auswerteeinrichtung 41, die eine Datenprozessor- und eine Eingabe-/Ausgabe-Einheit enthält.

Der Taktsignalgenerator 43 erzeugt ein internes Taktsignal mit konstanter Periodendauer, mit dem alle internen Funktionsblöcke des Logikanalysators arbeiten.

Da alle Signalerfassungsmodule 24, 34, etc. den gleichen Aufbau und die gleiche Funktionsweise haben, wird nachstehend lediglich das Signalerfassungsmodul 24 näher beschrieben. Gleiche Teile der Signalerfassungsmodule werden in Fig. 2 mit ähnlichen Bezugszeichen bezeichnet. So z.B. werden die Taktwähler mit 51 und 51′ bezeichnet.

Das Signalerfassungsmodul 24 enthält einen Taktwähler 51, ein Abtastregister 52, einen Abtastdetektor 53, eine Synchronisierungsschaltung 54, einen Datenspeicher 55, eine Speichersteuerung 56 und einen Ereignisdetektor 57.

Der Taktwähler 51 ist ein programmierbarer Demultiplexer, mit dem entweder das interne, vom Taktsignalgenerator 43 gelieferte Taktsignal, dessen Periode konstant ist, oder ein externes, vom Prüfling 21 abgeleitetes und über die Leitung 22 übertragenes Taktsignal wählbar ist, wobei das gewählte Taktsignal am Ausgang des Taktwählers 51 als Abtast-Taktsignal abgegeben wird. Für eine asynchrone Abtastung (Timing Analyzer Modus) wird das interne Taktsignal aus dem Generator 43 verwendet. Für eine synchrone Abtastung (State Analyzer Modus) wird ein externes, vom Prüfling abgeleitetes Taktsignal verwendet.

Wie in Fig. 3 gezeigt, werden im Abtastregister 52 die vom Prüfling 21 über m Leitungen 23 kommenden Datensignale mit dem am Ausgang des Taktwählers 51 über eine Leitung 58 abgegebenen Abtast-Taktsignal abgetastet und als abgetastete Datensignale über m Leitungen 61 an das Synchronisierungsregister weitergeleitet.

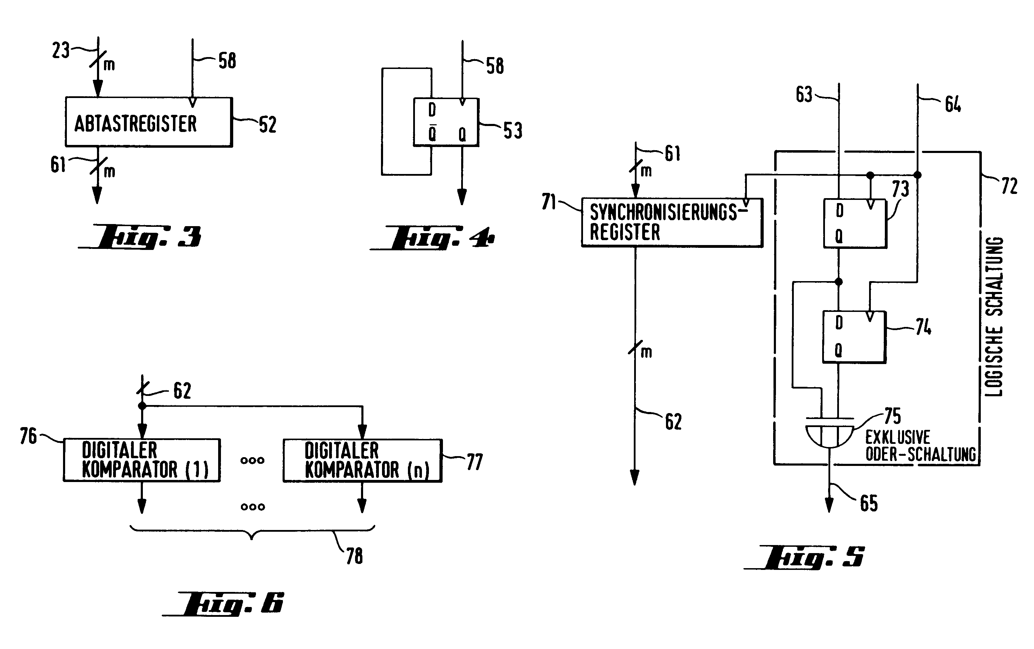

Im Ansprechen auf das am Ausgang des Taktwählers und über die Leitung 58 abgegebene Abtast-Taktsignal 51 gibt der Abtastdetektor 53 für jede Abtastung als Ausgangssignal ein Abtastsignal, dessen Polarität zum Zeitpunkt der Abtastung wechselt und somit diesen Zeitpunkt erkennbar macht. Wie in Fig. 4 gezeigt, ist der Abtastdetektor 53 z.B. ein D-Kippglied.

Fig. 5 zeigt eine Ausführungsform der Synchronisierungsschaltung 54. Diese Schaltung enthält ein Synchronisierungsregister 71 und eine logische Schaltung 72, die aus der in Fig. 5 gezeigten Schaltung von D-Kippgliedern 73 und 74 und einer Exklusives- ODER-Schaltung 75 besteht. Den Takteingängen des Synchronisierungsregisters 72 und der Kippglieder 73 und 74 wird das interne Taktsignal aus dem Generator 43 über eine Leitung 64 zugeführt. Im Synchronisierungsregister 71 werden die abgetasteten, vom Abtastregister 52 abgegebenen abgetasteten Datensignale mit dem internen Taktsignal aus dem Generator 43 abgetastet und als synchronisierte Datensignale über Leitungen 62 abgegeben. In der logischen Schaltung 72 wird das vom Abtastdetektor 53 abgegebene und dem D-Eingang des Kippgliedes 73 über eine Leitung 63 zugeführte Abtastsignal ebenfalls mit dem internen Taktsignal abgetastet. Auf diese Weise wird am Ausgang der logischen Schaltung 72 ein Abtastungs-Markierungsimpuls erzeugt und über eine Leitung 65 abgegeben, der dem Abtastsignal entspricht und somit den Zeitpunkt einer Abtastung markiert.

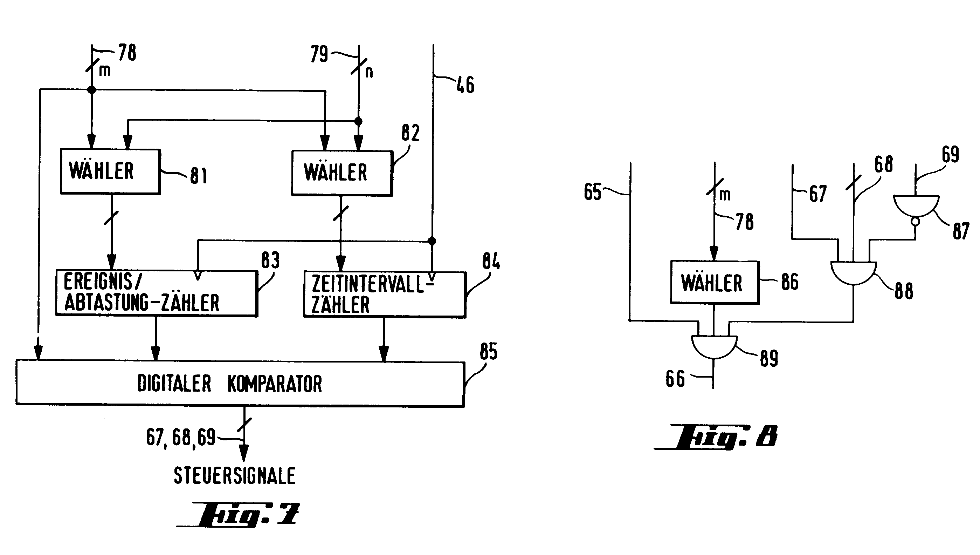

Wie in Fig. 6 gezeigt, enthält der Ereignisdetektor 57 eine Anzahl Komparatoren 76,77, etc., die durch den Benutzer programmierbare Muster mit den über die Leitungen 62 übertragenen Datensignalen vergleichen und bei Uebereinstimmung über Leitungen 78 Ausgangssignale abgeben, die Ereignissen entsprechen.

Mit der Speichersteuerung 56 werden die von einer für mehrere Signalerfassungsmodule 24,34, etc. gemeinsamen Triggerungssteuerung 42 abgegebenen Steuersignale, ein oder mehrere Ausgangssignale des Ereignisdetektors 57 und ein oder mehrere Abtastungs-Markierungsimpulse logisch verknüpft, um als Ausgangssignal einen Aufzeichnungs-Markierungsimpuls zu erzeugen, der über eine Leitung 66 übertragen wird und die Speicherung im Datenspeicher 55 von Datensignalen bewirkt, die aus dem Synchronisierungsregister 71 im Ansprechen auf das interne Taktsignal gelesen werden, und deren zeitliche Lage von einem korrespondierenden Abtastungs-Markierungsimpuls markiert wird.

Fig. 8 zeigt den Aufbau der Speichersteuerung 56. Diese enthält einen Inverter 87, UND-Tore 88,89 und einen programmierbaren Wähler 86. Die Speichersteuerung 56 empfängt als Eingangssignale: Abtastungs-Markierungsimpulse über die Leitung 65, Ausgangssignale des Ereignisdetektors 57 über die Leitungen 78 und von der Triggerungssteuerung 42 abgegebenen Steuersignale (ENABLE, START, STOP) über Leitungen 67, 68, 69. Durch eine programmierbare Verknüpfung dieser Eingangssignale erzeugt die Speichersteuerung 56 Aufzeichnungs-Markierungsimpulse, die am Ausgang des UND-Tors 89 über die Leitung 66 abgegeben werden.

Der Datenspeicher 55 übernimmt die synchronisierten, über die Leitungen 62 abgegebenen Datensignale am Ausgang des Synchronisierungsregisters 71 der Synchronisierungsschaltung 54, wenn zum Zeitpunkt des Auftretens eines internen Taktsignals ein Aufzeichnungs-Markierungsimpuls vorliegt. Nach Beendigung einer Messung werden die im Datenspeicher 55 abgespeicherten Daten als erfasste Datensignale von der Auswerteeinrichtung 41 ausgelesen.

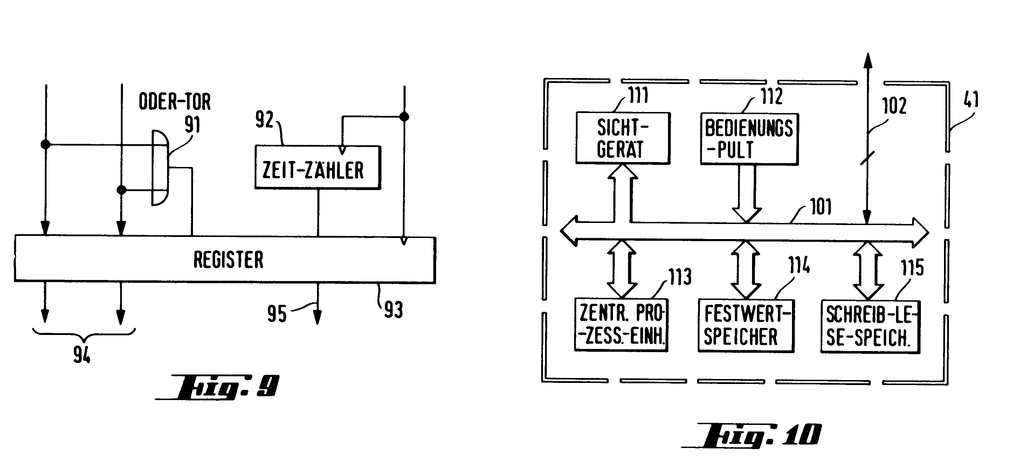

Die Fig. 7 zeigt den Aufbau der Triggersteuerung 42 in Fig. 2. Die Triggersteuerung 42 enthält programmierbare Wähler 81,82, einen Ereignis/Abtastungs-Zähler 83, einen Zeitintervall-Zähler 84 und einen digitalen Komparator 85. Die Triggersteuerung 42 empfängt folgende Eingangssignale: über Leitungen 78 Ausgangssignale des Ereignisdetektors 57, die einem oder mehreren Ereignissen entsprechen, über Leitungen 79 einen oder mehrere Abtastungs-Markierungsimpulse und über eine Leitung 46 das interne Taktsignal, das den Takteingängen der Zähler 83 und 84 zugeführt wird. Im Ansprechen auf entsprechende Eingangssignale gehen Befähigungs- bzw. Rückstellimpulse von Wähler 81 zum Zähler 83 und Rückstellimpulse vom Wähler 82 zum Zähler 84. Die Triggersteuerung 42 erzeugt Steuersignale durch Zählen von Signalen, die Ereignissen entsprechen, Abtastungs-Markierungsimpulsen und Impulsen des internen Taktsignals, und durch Vergleich der sich daraus ergebenden Zählerstände mit vom Benutzer programmierten Werten. Die mit der Triggersteuerung 42 erzeugten Steuersignale bestehen aus Start-, Stop- und Enable-Signalen. Diese Signale werden am Ausgang des Komparators 85 über entsprechende Leitungen 67, 68, 69 abgegeben. Diese Steuersignale werden der Speichersteuerung 56 zugeführt.

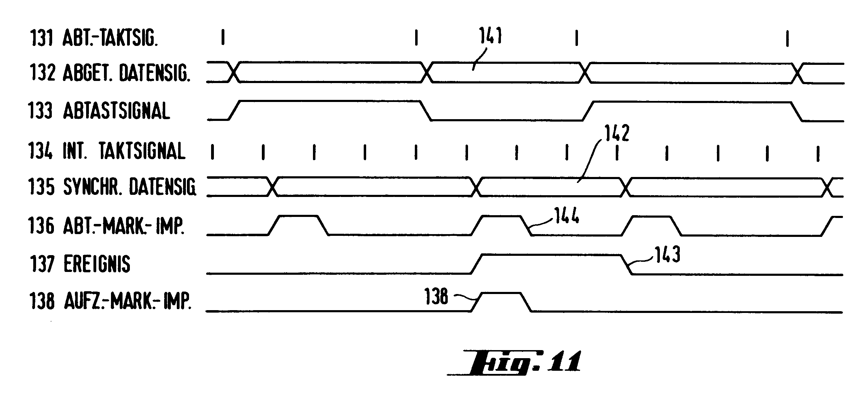

Die Fig. 9 zeigt den Aufbau der Zeitintervall-Messchaltung 45. Diese enthält ein ODER-Tor 91, einen Zeit-Zahler 92 und ein Register 93. Die Zeitintervall-Messchaltung 45 misst mit dem Zähler 92, welcher mit dem internen Taktsignal inkrementiert, die Zeitintervalle zwischen den Aufzeichnungs-Markierungsimpulsen, die den Eingängen des ODER-Tors 91 zugeführt werden, in beliebiger Reihenfolge auftreten und aus verschiedenen Signalerfassungsmodulen kommen können, und speichert bei Auftreten eines Aufzeichnungs-Markierungsimpulses diesen Impuls und das Zeitintervall in dem Register 93. Diese Signale können über entsprechende Ausgangsleitungen 94 bzw. 95 gelesen werden.

Im Zeitintervall-Speicher 44 wird jedes mit der Zeitintervall-Messchaltung 45 gemessene Zeitintervall und der jeweilige Aufzeichnungs-Markierungsimpuls, welcher ein Zeitintervall beendet hat, nach Auftreten eines Intervall-Endes abgespeichert. Diese abgespeicherten Daten werden von der Auswerteeinrichtung 41 ausgelesen.

Die Fig. 10 zeigt den Aufbau der Auswerteeinrichtung 41. Diese Einrichtung 41 enthält eine zentrale Prozessoreinheit 113, einen Festwertspeicher 114, einen Schreib-Lese-Speicher 115, ein Bedienungspult 112 und ein Sichtgerät 111. Diese Komponenten sind über eine Busleitung 101 miteinander verbunden. Die Auswerteeinrichtung 41 ist über Leitungen 102 und über die Busleitung 101 mit den Datenspeichern 55, 55′, etc. der Signalerfassungsmodule und mit dem Zeitintervallspeicher 44 verbunden.

Die Auswerteeinrichtung 41 liest die in den Datenspeichern 55 der verschiedenen Signalerfassungsmodule und in den Zeitintervall-Speichern 44 gespeicherten Werte und ermöglicht beispielsweise die Darstellung der Datensignale aus mehreren Signalerfassungsmodulen in zeitrichtiger Reihenfolge und Abstand auf einem Bildschirm in beliebiger Codierung.

In einer Variante der Erfindung wird mit der Zeitintervall-Messchaltung 45 anstelle der Zeitintervalle zwischen Aufzeichnungs-Markierungsimpulsen jeweils die absolute Zeit seit Beginn einer Messung bei Auftreten eines Aufzeichnungs-Markierungsimpulses abgespeichert. Auf diese Weise wird ebenfalls das Ende eines gemessenen Zeitintervalls markiert. Durch diese Variante wird die spätere Auswertung der Datensignale erheblich erleichtert.

In einer weiteren Variante des oben beschriebenen Logikanalysators enthält jedes Signalerfassungsmodul seine eigene Zeitintervall-Messchaltung und seinen eigenen Zeitintervallspeicher, und diese können ebenfalls absolute Zeiten messen bzw. speichern. In dieser Variante sind deshalb die in Fig. 2 gezeigten und für mehrere Signalerfassungsmodule gemeinsamen Zeitintervall-Messchaltung 45 und der Zeitintervall-Speicher 44 nicht mehr notwendig. Alle Zeitintervall-Messchaltungen werden gleichzeitig bei Beginn einer Messung gestartet. Dadurch wird auch in diesem Fall ein gemeinsamer Zeitmasstab definiert. Diese Variante hat Vorteile in Bezug auf die Realisierung der Schaltung.

Wie in der Fig. 2 gezeigt, erfolgt die interne Verarbeitung der abgetasteten Datensignale am Ausgang des Abtastregisters 52 in einer synchronen Architektur, die mit einem konstanten internen Takt betrieben wird. Erfindungsgemäss wird also ein zweistufiges Abtastungsverfahren angewendet. Dieses Verfahren wird nun anhand des Blockdiagramms in der Fig. 2 und der in Fig. 11 dargestellten Signalabläufe erläutert:

Die Fig. 11 illustriert ein Ausführungsbeispiel, bei dem:

- die Datensignale mit einem externen, von einem Prüfling abgeleiteten Taktsignal abgetastet und in den Abtastregister 52 geladen werden,
- der Ereignisdetektor 57 so programmiert ist, dass er ein Muster sucht, das in einem Block 141 von Datensignalen "Data n" vorkommt und gegebenenfalls ein entsprechendes Ausgangssignal 137 erzeugt, bei dem ein Impuls 143 einem "Ereignis n" entspricht, und
- die Speichersteuerung 56 so programmiert ist, dass der von der Synchronisierungsschaltung 54 abgegebene Block von Datensignalen 142 in den Datenspeicher 55 nur dann übernommen wird, wenn ein "Ereignis n" vorliegt. Hierfür wird aus einem Abtastungs-Markierungsimpuls 144 ein Aufzeichnungs-Markierungsimpuls 138 nur dann abgeleitet, wenn ein dem "Ereignis n" entsprechender Impuls 143 vorliegt.

Die vom Prüfling 21 empfangenen Datensignale werden mit dem, in dem Taktwähler 51 ausgewählten Takt abgetastet und in den Abtastregister 52 geladen. Im Beispiel gemäss Fig. 11 wird eine Abtastung mit einem externen vom Prüfling abgeleiteten Taktsignal 131 verwendet. Gleichzeitig mit jeder Abtastung wechselt das am Ausgang des Abtastdetektors 53 gelieferten Abtastsignal 133 seine Polarität. Danach werden die im Abtastregister 52 gespeicherten Datensignale 132 zusammen mit dem Abtastsignal 133 in der Synchronisierungsschaltung 54 mit dem internen Taktsignal nochmals abgetastet und auf diese Weise für die gesamte weitere Verarbeitung mit dem internen Taktsignal synchronisiert. Aus dem Abtastsignal 133 wird dabei für jeden Polaritätswechsel dieses Signals ein eine interne Taktperiode langer Abtastungs-Markierungsimpuls erzeugt. Die Wellenform 136 in Fig. 11 zeigt mehrere solcher Markierungsimpulse. Die Abtastungs-Markierungsimpulse 136 werden parallel mit den synchronisierten Datensignalen 135 in den nachgeschalteten Bearbeitungs-Stufen. Speichersteuerung 56 und Triggersteuerung 42, ausgewertet. Die Abtastungs-Markierungsimpulse liefern diesen Verarbeitungs-Stufen die durch die Synchronisierung verlorengegangene Zeitinformation über den Zeitpunkt jeder Abtastung.

Wenn in der Speichersteuerung 56 aus einem Abtastungs-Markierungsimpuls ein Aufzeichnungs-Markierungsimpuls erzeugt wird, werden die synchronisierten Datensignale 135 zum Datenspeicher 55 übertragen.

In der Zeitintervall-Messchaltung 45 wird der Zeitabstand zwischen dem Auftreten der Aufzeichnungs-Markierungsimpulse aller Signalerfassungsmodule 24, 34, etc. gemessen. Diese Zeitintervalle und die jeweils aufgetretenen Aufzeichnungs-Markierungsimpulse werden in dem Zeitintervallspeicher 44 abgespeichert. Diese Informationen ermöglichen, in der Auswerteeinrichtung 41 die zeitlichen Verhältnisse zwischen den mit verschiedenen Signalerfassungsmodulen erfassten Datensignalen zeitrichtig, d.h. in absoluten Zeiten zu rekonstruieren und darzustellen.

Das oben beschriebene, erfindungsgemässe zweistufige Abtastungsverfahren ermöglicht ausserdem:

- die Erkennung und Verarbeitung von Daten von zueinander asynchronen Prüfobjekten, wobei keine Master-Clock-Definition erforderlich ist und wobei Triggerworte (mittels der internen Verarbeitung mit einem internen Taktsignal konstanter Periodendauer) über die ganze Breite der Kanäle aller Prüfobjekte definiert werden können,
- immer gleichlange Verarbeitungszeiten in allen Signalerfassungsmodulen unabhängig von der Periodendauer der dem Abtastregister zugeführten Taktsignale. Dies ermöglicht eine präzise Ansteuerung von weiteren Geräten (Echtzeitkopplung von z.B. Emulatoren, Wortgeneratoren, Oszilloskopen, etc.).

Ein weiterer Vorteil des erfindungsgemässen, zweistufigen Abtastungsverfahren ist, dass dabei kein eingetaktetes Datenwort verloren geht, da kein externer Takt benötigt wird, um weitere Register zu füllen oder zu leeren.

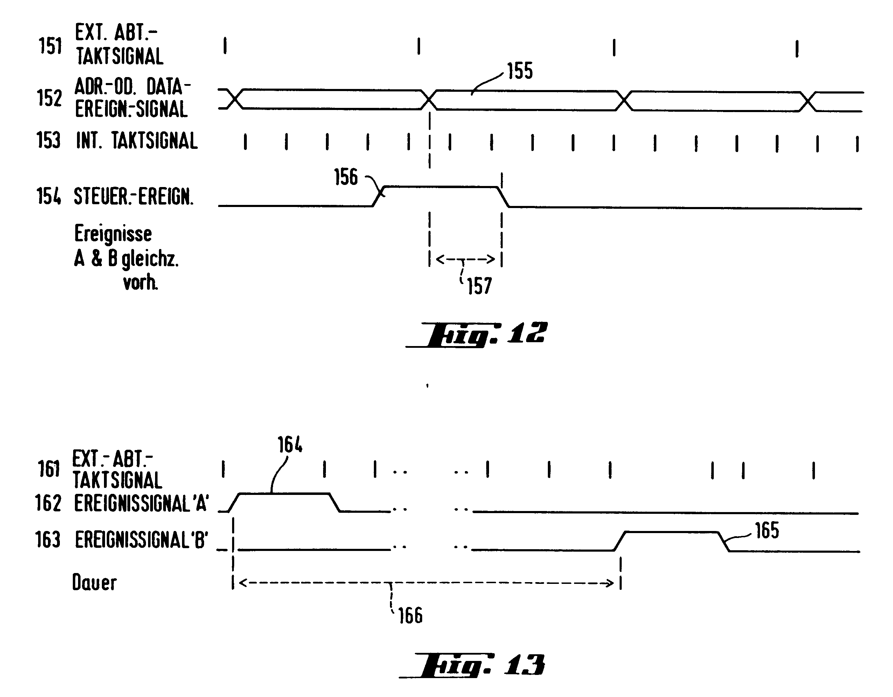

Nachstehend werden nun anhand der in den Figuren 12-16 dargestellten Signalabläufe weitere vorteilhaften technischen Wirkungen erläutert, die mit dem erfindungsgemässen, oben beschriebenen Logikanalysator erzielt werden:

Beispiel 1

Wie in der Fig. 12 gezeigt, werden die Daten- und Adressensignale 152 eines Prozessors in einem ersten Signalerfassungsmodul und mit einem externen, vom Prozessor abgeleiteten Taktsignal 151 aufgezeichnet, seine Kontroll-Signale 154 werden hingegen in einem zweiten Signalerfassungsmodul und mit einem internen Taktsignal 153 aufgezeichnet, das zum externen Taktsignal asynchron ist. Die Aufzeichnung wird durch eine Triggerung beendet, wenn Ereignisse 155 und 156 gleichzeitig auftreten, die vorher vom Benutzer definiert und von den Daten- und Adressensignale bzw. von den Kontroll-Signalen abgeleitet werden. Gemäss Fig. 12 sind über ein Zeitintervall 157 beide Ereignisse 155 und 156 vorhanden.

Diese Beispiel zeigt, dass die Erfindung eine gleichzeitige Auswertung von Ereignissen von mehreren, verschiedenen Prüflingen in einer Triggersteuerung ermöglicht, wobei die von den Prüflingen abgegebenen Signale teilweise mit externen und teilweise mit internem Takt abgetastet werden. Diese gleichzeitige Auswertung von Ereignissen ist auch möglich, wenn die von den Prüflingen abgegebenen Signale jeweils mit einem externen, vom jeweiligen Prüfling abgeleiteten Taktsignal unbekannter Periodendauer abgetastet werden, und zwar auch dann, wenn die verschiedenen externen Taktsignale zueinander asynchron sind.

Durch die oben erwähnte Wirkung wird ein Vorteil gegenüber dem Stand der Technik erzielt. Bei den bisher bekannten Logikanalysatoren ist es nämlich notwendig, bei der Auswertung von Ereignissen in verschiedenen Datensignalen, die mit zueinander asynchronen Taktsignalen aufgezeichnet werden, das Taktsignal der Auswerteschaltung (Triggersteuerung) vom Taktsignal des jeweiligen Prüflings abzuleiten. Auf diese Weise können die Ereignisse zwar sequenziell, aber nicht gleichzeitig ausgewertet werden.

Beispiel 2

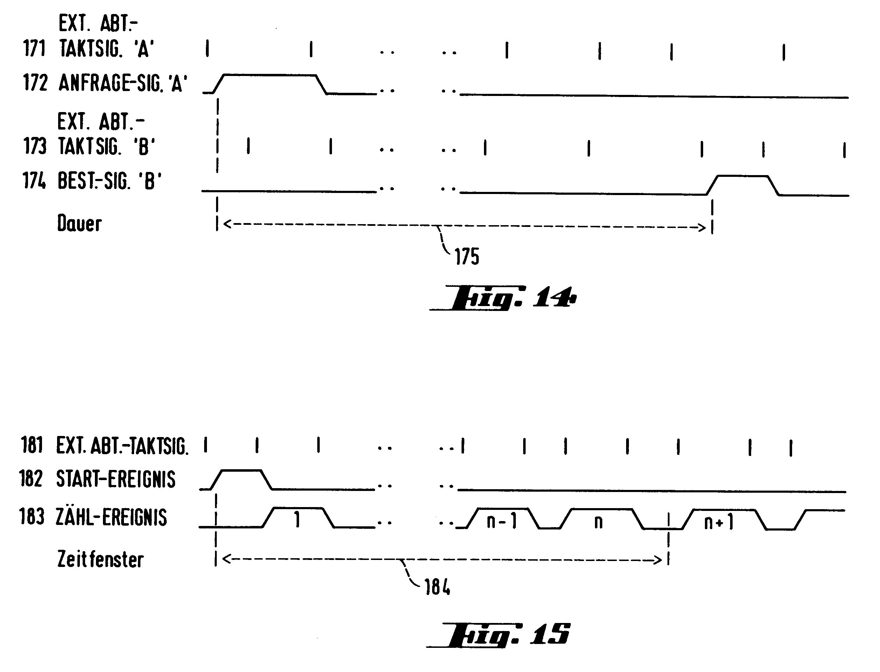

Wie anhand der Fig. 13 beschrieben, wird mit dem erfindungsgemässen Logikanalysator die Ausführungsdauer eines Programms überwacht, dessen Beginn beispielsweise durch das Ereignis 164 und dessen Ende durch das Ereignis 165 gekennzeichnet ist. Dafür werden Datensignale, in denen die Ereignisse 164 bzw. 165 vorkommen mit einem externen, vom Prüfling abgeleiteten Taktsignal 161 unbekannter Periodendauer abgetastet. Die Aufzeichnung dieser Signale wird durch eine Triggerung beendet, wenn der gemessene Zeitabstand 166 ein vom Benutzer zuvor definiertes Zeitintervall über- bzw. unterschreitet.

Dieses Beispiel zeigt, dass die Erfindung ermöglicht, während einer Aufzeichnung, die mit einem externen, vom Prüfling abgeleiteten Taktsignal unbekannter Periodendauer durchgeführt wird, Zeitabstände zwischen Ereignissen zu messen und diese Zeitabstände in einer Triggersteuerung auszuwerten. Bei den bisher bekannten Logikanalysatoren können derartige Zeitabstände nur bei Aufzeichnung der Datensignale mit einem internen Taktsignal bekannter Periodendauer gemessen werden.

Beispiel 3

Wie anhand der Fig. 14 beschrieben, werden mit dem erfindungsgemässen Logikanalysator Signalbläufe aufgezeichnet, die den Zugriff eines ersten Prozessors A auf den Bus eines zweiten Prozessors B in einem Multiprozessorsystem entsprechen. Mit dem Anfrage-Signal 172 fordert Prozessor A die Kontrolle über den Bus vom Prozessor B an. Der Prozessor B übergibt die Kontrolle mit dem Bestätigungs-Signal 174. Das vom Prozessor A abgegebene Anfrage-Signal 172 wird mit einem externen, vom Prozessor A abgeleiteten Taktsignal 171 abgetastet. Das vom Prozessor B abgegebene Bestätigungs-Signal 174 wird mit einem externen, vom Prozessor B abgeleiteten Taktsignal 173 abgetastet. Die Taktsignale 171 und 173 sind zueinander asynchron. Die Aufzeichnung der Signalabläufe, die den Zugriff des Prozessors A auf dem Bus des Prozessors B entsprechen, wird durch eine Triggerung beendet, wenn z.B. der gemessene Zeitabstand 175 zwischen dem Anfrage-Signal 172 und dem Bestätigungs-Signal 174 ein vom Benutzer zuvor definiertes Zeitintervall über- bzw. unterschreitet.

Beim erfindungsgemässen Logikanalysator werden während einer Aufzeichnung Zeitabstände zwischen Ereignissen in den Datensignalen von mehreren, verschiedenen Prüflingen gemessen, wobei die Datensignale jeweils mit einem externen, vom jeweiligen Prüfling abgeleiteten Taktsignal unbekannter Periodendauer abgetastet werden.

Dieses Beispiel zeigt, dass der erfingungsgemässe Logicanalysator ermöglicht, die gemessenen Zeitabstände in einer Triggersteuerung auszuwerten. Wie aus Fig. 14 ersichtlich, wird dies auch dann erzielt, wenn die verschiedenen externen Taktsignale zueinander asynchron sind.

## Beispiel 4

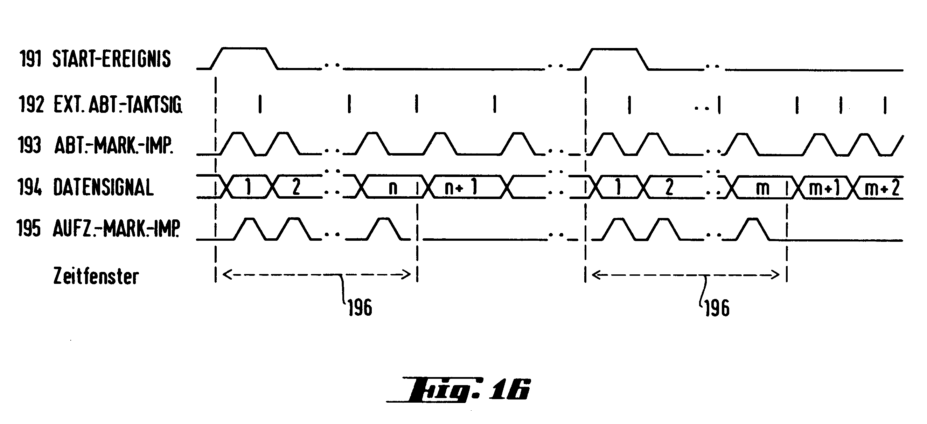

Wie anhand der Fig. 15 beschrieben, werden mit einem erfindungsgemässen Logikanalysator Signalabläufe aufgezeichnet, die mit einem externen, vom Prüfling abgeleiteten Taktsignal 181 abgetastet werden. Nach Aufruf eines Unterprogramms mit einem Startereignis-Signal 182 und während der Aufzeichnung der Signalabläufe wird überprüft, ob eine Anzahl n von Datenübertragungen (Zählereignis) 183 zu einem Ausgaberegister innerhalb eines bestimmten Zeitintervalls 184 stattgefunden haben. Der Benutzer definiert zuvor die Grösse des Zeitfensters 184, die Anzahl n der Datenübertragungen (Ereignisse) und wie die Triggersteuerung darauf reagieren soll.

Dieses Beispiel zeigt, dass die Erfindung ermöglicht, während einer Aufzeichnung, die mit einem externen, vom Prüfling abgeleiteten Takt unbekannter Periodendauer durchgeführt wird, die Zahl von Ereignissen innerhalb oder ausserhalb eines Zeitfensters zu zählen, und dieses Zähl-Ergebnis in einer Triggersteuerung auszuwerten.

## Beispiel 5

Wie nun anhand der Fig. 16 beschrieben, werden mit einem erfindungsgemässen Logikanalysator Datensignale 194 aufgezeichnet, die innerhalb eines Zeitintervalls 196 jedes Mal nach einem Startereignis-Signal 191 stattfinden. Das Zeitintervall 196 wird vom Benutzer vor der Aufzeichnung definiert. Wie aus der Fig. 16 ersichtlich werden die Datensignale mit einem externen, vom Prüfling abgeleiteten Taktsignal 192 abgetastet. Bei der Aufzeichnung werden die in Fig. 16 dargestellten Abtastungs-Markierungsimpulse 193 und die Aufzeichnungs-Markierungsimpulse 195 erzeugt.

Dieses Beispiel zeigt, dass die Erfindung ermöglicht, während einer Aufzeichnung, die mit einem externen, vom Prüfling abgeleiteten Taktsignal unbekannter Periodendauer durchgeführt wird, die Aufzeichnung der Datensignale durch Freigabe der Uebernahme abgetasteter Datensignale in den Datenspeicher 55 innerhalb oder ausserhalb eines Zeitintervalls zu steuern. Bei den bisher bekannten Logikanalystoren kann hingegen die Uebernahme und dadurch die Aufzeichnung von Datensignalen, die mit einem externen, vom Prüfling abgeleiteten Taktsignal unbekannter Periodendauer abgetastet werden, nur durch das Vorliegen von Ereignissen gesteuert werden.

## Beispiel 6

Anhand der in den Datenspeichern 55 gespeicherten und mit der Auswerteeinrichtung 41 ausgewerteten Signale wird durch den erfindungsgemässen Logikanalysator eine zeitkorrelierte Darstellung der Aufzeichnungen von Datensignalen von mehreren Prüflingen ermöglicht, welche Datensignale jeweils mit einem externen, vom jeweiligen Prüfling abgeleiteten Taktsignal unbekannter Periodendauer abgetastet werden, und zwar auch dann, wenn die verschiedenen Taktsignale zueinander asynchron sind. Durch die Verwendung der oben beschriebenen Zeitintervall-Messchaltung 45 und des Zeitintervall-Speichers ist es dabei möglich, sowohl die zeitliche Reihenfolge der Datensignale als auch den quantitativen zeitlichen Abstand der Abtastungen zueinander darzustellen. Mit den bisher bekannten Logikanalystoren können solche Aufzeichnungen (d.h. die Aufzeichnungen von Datensignalen von zwei verschiedenen Prüflingen mit zueinander asynchronen Taktsignalen) lediglich in der zeitlichen Aufeinanderfolge ihrer Abtastungen dargestellt werden. Mit den bereits bekannten Logikanalysatoren ist es jedoch nicht möglich, quantitative Angaben über den tatsächlichen zeitlichen Abstand der Abtastungen zueinander zu machen.

## Patentansprüche

1. Logikanalysator mit wenigstens einem Signalerfassungsmodul (24, 34), das an einen ihm zugeordneten Prüfling (21, 31) anschließbar ist, mit einem Taktwähler (51), mit dem entweder ein internes Taktsignal, dessen Periode konstant ist, oder ein externes, vom Prüfling abgeleitetes Taktsignal wählbar ist, wobei das gewählte Taktsignal am Ausgang des Taktwählers als Abtast-Taktsignal abgegeben wird, mit einem Abtastregister (52), zur Speicherung von Datensignalen, die vom Prüfling abgegeben werden, und die mit dem Abtast-Taktsignal abgetastet werden, mit einer Synchronisierungsschaltung (54), die ein Synchronisierungsregister zur Speicherung von Datensignalen, die aus dem Abtastregister im Ansprechen auf das Abtast-Taktsignal gelesen und mit dem internen Taktsignal abgetastet werden, und eine logische Schaltung enthält, die im Ansprechen auf das interne Taktsignal und auf das Abtastsignal Abtastungs-Markierungsimpulse abgibt, die je den Zeitpunkt einer Abtastung markieren, mit einer Speichersteuerung (56), die als Ausgangssignal einen Aufzeichnungs-Markierungsimpuls erzeugt, der die Speicherung von Datensignalen bewirkt, die aus dem Synchronisierungsregister im Ansprechen auf das interne Taktsignal gelesen werden, und deren zeitliche Lage von einem korrespondierenden Abtastungs-Markierungsimpuls markiert wird, und mit einem von der Speichersteuerung (56) gesteuerten Datenspeicher zur Speicherung von Datensignalen, die aus dem Synchronierungsregister gelesen werden,
dadurch gekennzeichnet, daß ein Abtastdetektor, der im Ansprechen auf das Abtast-Taktsignal für jede Abtastung als Ausgangssignal ein Abtastsignal abgibt, das den Zeitpunkt der Abtastung erkennbar macht, ein Ereignisdetektor (57) der aus dem Synchronisierungsregister der Synchronisierungsschaltung gelesene Datensignale mit vorgegebenen Muster vergleicht und bei Übereinstimmung ein Ausgangssignal abgibt, das einem Ereignis entspricht, und eine Triggerungssteuerung vorgesehen ist, die durch Zählen von Ausgangssignalen des Ereignisdetektors, Abtastungs-Markierungsimpulsen und Impulsen des internen Taktsignals, und durch Vergleich der sich daraus ergebenden Zählerstände mit vorgegebenen Werten Steuersignale erzeugt, die der Speichersteuerung des Signalerfassungsmoduls zugeführt werden, und daß die Speichersteuerung (56) zur Erzeugung eines Aufzeichnungs-Markierungsimpulses als Ausgangssignal die von der Triggerungssteuerung abgegebenen Steuersignale, eines oder mehrere Ausgangssignale des Ereignisdetektors (57) und einen oder mehrere Abtastungs-Markierungsimpulse logisch verknüpft.

2. Logikanalysator gemäß Anspruch 1, dadurch gekennzeichnet, daß er eine Zeitintervall-Meßschaltung (45), mit der die Zeitintervalle zwischen Aufzeichnungs-Markierungsimpulsen gemessen werden, und einen Zeitintervall-Speicher (44) zur Speicherung der gemessenen Zeitintervalle und der Aufzeichnungs-Markierungsimpulse enthält, die jeweils das Ende eines gemessenen Zeitintervalls markieren.

3. Logikanalysator gemäß Anspruch 2, dadurch gekennzeichnet, daß er eine Auswerteeinrichtung (41) enthält, mit der nach Beendigung einer Messung die im Datenspeicher (55) gespeicherten Datensignale und die im Zeitintervall-Speicher (44) gespeicherten Zeitintervalle gelesen und verarbeitet werden.

4. Logikanalysator gemäß einem der vorhergehenden Ansprüche, dadurch gekennzeichnet, daß er wenigstens zwei Signalerfassungsmodule (24, 34) und eine für mehrere solche Module gemeinsame Triggerungssteuerung (42) enthält.

5. Logikanalysator gemäß Anspruch 4, dadurch gekennzeichnet, daß die Triggerungssteuerung (42) durch Zählen von Ausgangssignalen der Ereignisdetektoren, Abtastungs-Markierungsimpulsen und Impulsen des internen Taktsignals, unter Vergleich der sich daraus ergebenden Zählerstände mit vorgegebenen Werten Steuersignale erzeugt, die den Speichersteuerungen der Signalerfassungsmodule zugeführt werden.

6. Logikanalysator gemäß Anspruch 4 oder 5, dadurch gekennzeichnet, daß er eine Zeitintervall-Meßschaltung (45), mit der die Zeitintervalle zwischen den von den Signalerfassungsmodulen (24, 34) abgegebenen Aufzeichnungs-Markierungsimpulsen gemessen werden, und einen Zeitintervall-Speicher (44) zur Speicherung der gemessenen Zeitintervalle und der Aufzeichnungs-Markierungsimpulse enthält, die jeweils das Ende eines gemessenen Zeitintervalls markieren.

7. Logikanalysator gemäß Anspruch 6, dadurch gekennzeichnet, daß er eine Auswerteeinrichtung enthält, mit der nach Beendigung einer Messung die in den Datenspeichern (55) gespeicherten Datensignale und die im Zeitintervall-Speicher (44) gemessenen Zeitintervalle gelesen und verarbeitet werden.

## Claims

1. A logic analyser comprising at least one signal acquisition module (24, 34) for connecting to an associated test-piece (21, 31) and comprising a timing selector (51) for selecting either an internal timing signal having a constant period or an external timing signal derived from the test-piece, the selected timing signal being delivered in the form of a scanning timing signal at the output of the timing selector; a scanning register (52) for storing data signals delivered by the test-piece and scanned by the scanning timing signal; a synchronisation circuit (54) containing a synchronisation register for storing data signls read out of the scanning register in response to the scanning timing signal and scanned by the internal timing signal and also comprising a logic circuit which responds to the internal timing signal and to the scanning signal by delivering scanning marker pulses which each mark the time of a scanning operation; a store control means (56) which generates an output signal in the form of a recording marker pulse which brings about storage of data signals which are read out of the synchronisation register in response to the internal timing signal and the position of which in time is marked by a corresponding scanning marker pulse; and a data store controlled by the store control means (56) and for storing signals read out of the synchronisation register, characterised in that a scanning detector which responds to the scanning timing signal by delivering an output signal for each scanning operation, the output signal being in the form of a scanning signal showing the time of the scanning operation; an event detector (57) which compares a preset sample with the data signals read out of the synchronisation register of the synchronisation circuit and, if there is agreement, delivers an output signal corresponding to an event; and a trigger control means are provided, and the trigger control counts the output signals from the event detector, the scanning marker pulses and the pulses of the internal timing signal and compares the resulting counts with preset values in order to generate control signals which are supplied to the store control means in the signal acquisition module, and the storage control means (56), in order to generate an output signal in the form of a recording marker pulse, logically combines the control signals delivered by the triggering control means, one or more output signals of the event detector (57), and one or more scanning marker pulses.

2. A logic analyser according to claim 1, characterised in that it contains a time interval measuring circuit (45) for measuring the time intervals between recording marker pulses, and a time interval store for storing the measured time intervals and the recording marker pulses marking the end of a measured time interval.

3. A logic analyser according to claim 2, characterised in that it contains an evaluating device (41) for reading and processing the data signals stored in the data store (55) and the time intervals stored in the time-interval store (44) at the end of a measurement.

4. A logic analyser according to any of the preceding claims, characterised in that it contains at least two signal acquisition modules (24, 34) and a common triggering control means (42) for a number of such modules.

5. A logic analyser according to claim 4, characterised in that the triggering control means (42) counts the output signals from the event detectors, the scanning marker pulses and the pulses of the internal timing signal and compares the resulting counts with preset values in order to generate control signals which are supplied to the store control means in the signal acquisition modules.

6. A logic analyser according to claim 4 or 5, characterised in that it contains a time-interval measuring circuit (45) for measuring the time intervals between the recording marker pulses delivered by the signal acquisition modules (24, 34) and also contains a time interval store (44) for storing the measured time intervals and the recording marker pulses for marking the end of a measured time interval.

7. A logic analyser according to claim 6, characterised in that it contains an evaluating device for reading and processing the data signals stored in the data stores (55) and the time intervals measured in the time interval store (44) at the end of a measurement.

## Revendications

1. Analyseur logique comportant au moins un module de saisie de données (24,34) destiné à être relié à l'élément à contrôler (21, 31) qui lui est associé, et comportant un sélecteur d'horloge (51) permettant de choisir entre un signal d'horloge interne dont la période est constante ou un signal d'horloge externe provenant de l'élément à contrôler, le signal d'horloge choisi étant fourni à la sortie du sélecteur d'horloge comme signal d'horloge de détection, un registre de détection (52) pour enregistrer des signaux de données fournis par l'élément à contrôler et qui sont détectés par le signal d'horloge de détection, un circuit de synchronisation (54) qui comporte un registre de synchronisation pour mettre en mémoire des signaux de données lus dans le registre de détection en réponse au signal d'horloge de détection pour être détecté par le signal d'horloge interne et un circuit logique fournissant des impulsions de marquage de détection en réponse au signal d'horloge interne et au signal de détection, ces impulsions repérant chaque instant d'une détection, une commande de mémoire (56) générant comme signal de sortie une impulsion de marquage d'inscription qui provoque la mise en mémoire des signaux de données lus dans le registre de synchronisation en réponse au signal d'horloge interne et dont la position dans le temps est marquée par une impulsion de marquage de détection correspondante, ainsi qu'une mémoire de données commandée par la commande de mémoire (56) pour enregistrer les signaux de données lus dans le registre de synchronisation, analyseur caractérisé par un détecteur qui en réponse au signal d'horloge de détection, fournit un signal de détection comme signal de sortie pour chaque détection, et rendant reconnaissable l'instant de la détection, un détecteur d'événements (57) qui compare un modèle prédéterminé, les signaux de données lus dans le registre de synchronisation du circuit de synchronisation et qui en cas de coïncidence, fournit un signal de sortie correspondant à un événement ainsi qu'une commande de déclenchement qui, par sélection de signaux de sortie du détecteur d'événements, des impulsions de marquage de détection et les impulsions du signal d'horloge interne et par comparaison des états de comptage qui en résultent avec des valeurs prédéterminées, génèrent des signaux de commande qui sont fournis à la commande de mémoire du module de saisie de signaux et en ce que la commande de mémoire (56) combine de manière logique pour créer une impulsion de marquage d'inscription constituant le signal de sortie, les signaux de commande fournis par la commande de déclenchement, un ou plusieurs signaux de sortie du détecteur d'événements (57) et une ou plusieurs impulsions de marquage de détection.

2. Analyseur logique selon la revendication 1, caractérisé en ce qu'il comporte un circuit de mesure d'intervalle de temps (45) qui mesure les intervalles de temps entre les impulsions de marquage d'inscription et une mémoire d'intervalle de temps (44) pour enregistrer les intervalles de temps mesurés et qui contient les impulsions de marquage d'inscription marquant chaque fois la fin d'un intervalle de temps mesuré.

3. Analyseur logique selon la revendication 2, caractérisé en ce qu'il comporte un circuit d'exploitation (41) qui à la fin d'une mesure, lit et traite les signaux de données enregistrés dans la mémoire de données (55) et les intervalles de temps enregistrés dans la mémoire d'intervalle de temps (44).

4. Analyseur logique selon l'une des revendications précédentes, caractérisé en ce qu'il comporte au moins deux modules de saisie de signaux (24, 34) et une commande de déclenchement (42) commune à plusieurs tels modules.

5. Analyseur logique selon la revendication 4, caractérisé en que la commande de déclenchement (42) génère des signaux de commande par le comptage des signaux de sortie des détecteurs d'événements, les impulsions de marquage de détection et des impulsions du signal d'horloge interne en comparant les états de comptage qui en résultent à des valeurs prédéterminées qui sont fournies aux commandes de mémoire des modules de saisie de signaux.

6. Analyseur logique selon la revendication 4 ou 5, caractérisé en qu'il comporte un circuit de mesure d'intervalle de temps (45) qui mesure les intervalles de temps entre les impulsions de marquage d'inscription fournies par les modules de saisie de signaux (24, 34) et une mémoire d'intervalle de temps (44) pour mettre en mémoire les intervalles de temps mesurés et les impulsions de marquage d'inscription, repérant chaque fois la fin d'un intervalle de temps mesuré.

7. Analyseur logique selon la revendication 6, caractérisé en ce qu il comporte un circuit d'exploitation qui, à la fin d'une mesure, lit et traite les signaux de données inscrits dans les mémoires de données (55) et les intervalles de temps mesurés inscrits dans la mémoire d'intervalle de temps (44).

LOGIKANALYSATOR

TAKTSIGNALGENERATOR

TAKTWÄHLER

TRIGGERSTEUERUNG

DATENSPEICHER

AUSWERTEEINRICHTUNG

PRÜFLING

**Fig. 1**

Fig. 2

PRÜFLING (1) 21

PRÜFLING (n) 31

23 22 24

33 32 34

SIGNALERFASSUNGS-MODUL (1)

SIGNALERFASSUNGSMODUL (2)

TAKTWÄHLER 51

TAKTWÄHLER 51'

52

58

52'

58'

ABTAST-REGISTER

ABTAST-DETEKTOR 53

ABTAST-REGISTER

ABTAST-DETEKTOR 53'

54

SYNCHRONISIERUNGSSCHALTUNG

SYNCHRONISIERUNGSSCHALTUNG

62

55

54'

62'

55'

DATEN-SPEICHER

56

SPEICHER-STEUERUNG

57

EREIGNIS-DETEKTOR

DATEN-SPEICHER

56'

SPEICHER-STEUERUNG

57'

EREIGNIS-DETEKTOR

TAKTSIGNAL-GENERATOR

AUSWERTE-EINRICHTUNG 41

TRIGGERSTEUERUNG

ZEITINTERVALLE 42

43

ZEITINTERVALL-SPEICHER 44

ZEITINTERVALL-MESSSCHALTUNG 45

12

EP 0 318 768 B1

**Fig. 3** — 23 / m → ABTASTREGISTER (52) ← 58; 61 / m

**Fig. 4** — D, Q̄, Q (53) ← 58

**Fig. 5** — 71 → SYNCHRONISIERUNGS-REGISTER ← 61 / m; 63, 64; 73 (D Q), 74 (D Q), 72, 75 EXKLUSIVE ODER-SCHALTUNG, LOGISCHE SCHALTUNG; 62 / m; 65

**Fig. 6** — 62; 76 DIGITALER KOMPARATOR (1) ∘∘∘ DIGITALER KOMPARATOR (n) 77; 78

EP 0 318 768 B1

WÄHLER 81

WÄHLER 82

EREIGNIS/ ABTASTUNG-ZÄHLER 83

ZEITINTERVALL- ZÄHLER 84

DIGITALER KOMPARATOR 85

67, 68, 69

STEUERSIGNALE

**Fig. 7**

WÄHLER 86

**Fig. 8**

**ODER-TOR**
**91**
**92**
**ZEIT-ZÄHLER**
**REGISTER**
**95**
**93**
**94**

*Fig. 9*

**111** SICHT-GERÄT
**112** BEDIENUNGS-PULT
**102**
**41**
**101**
**113** ZENTR. PRO-ZESS.-EINH.
**114** FESTWERT-SPEICHER
**115** SCHREIB-LE-SE-SPEICH.

*Fig. 10*

EP 0 318 768 B1

**Fig. 11**

131 ABT.-TAKTSIG.
132 ABGET. DATENSIG.
133 ABTASTSIGNAL
134 INT. TAKTSIGNAL
135 SYNCHR. DATENSIG.
136 ABT.-MARK.-IMP.
137 EREIGNIS
138 AUFZ.-MARK.-IMP.

EP 0 318 768 B1

EP 0 318 768 B1

151 EXT. ABT.-TAKTSIGNAL

152 ADR.-OD. DATA-EREIGN.-SIGNAL

155

153 INT. TAKTSIGNAL

154 STEUER.-EREIGN.

156

Ereignisse
A & B gleichz.
vorh.

$\leftarrow\!\top\!\rightarrow$

157

*Fig. 12*

161 EXT.-ABT.-TAKTSIGNAL

164

162 EREIGNISSIGNAL 'A'

163 EREIGNISSIGNAL 'B'

165

Dauer

$\leftarrow\!-\!-\!-\!-\!-\!-\!-\!-\!-\!-\!-\!-\!-\!-\!-\!-\!-\!-\!-\!-\!-\!\rightarrow$

166

*Fig. 13*

EXT. ABT.-
171 TAKTSIG. 'A'

172 ANFRAGE-SIG. 'A'

EXT. ABT.-
173 TAKTSIG. 'B'

174 BEST.-SIG. 'B'

Dauer

175

**Fig. 14**

181 EXT. ABT.-TAKTSIG.

182 START-EREIGNIS

183 ZÄHL-EREIGNIS

Zeitfenster

1    n-1    n    n+1

184

**Fig. 15**

EP 0 318 768 B1

191 START-EREIGNIS

192 EXT. ABT.-TAKTSIG.

193 ABT.-MARK.-IMP.

194 DATENSIGNAL

195 AUFZ.-MARK.-IMP.

Zeitfenster

196          196

**Fig. 16**

EP 0 318 768 B1